# Europäisches Patentamt
# European Patent Office
# Office européen des brevets

(19)

(11) Veröffentlichungsnummer : **0 463 307 B1**

(12)

# EUROPÄISCHE PATENTSCHRIFT

(45) Veröffentlichungstag der Patentschrift :
**25.01.95 Patentblatt 95/04**

(51) Int. Cl.$^6$ : **G01R 23/00,** G01R 23/15

(21) Anmeldenummer : **91106087.9**

(22) Anmeldetag : **17.04.91**

(54) **Schaltungsanordnung zum Vergleichen einer Messfrequenz mit einer mit einem Faktor multiplizierten Referenzfrequenz.**

(30) Priorität : **27.06.90 DE 4020360**

(43) Veröffentlichungstag der Anmeldung :
**02.01.92 Patentblatt 92/01**

(45) Bekanntmachung des Hinweises auf die
Patenterteilung :
**25.01.95 Patentblatt 95/04**

(84) Benannte Vertragsstaaten :
**DE FR GB**

(56) Entgegenhaltungen :
**DE-A- 3 906 094**
**FR-A- 2 530 030**
**GB-A- 2 045 950**
**US-A- 3 877 003**
**US-A- 4 005 364**

(73) Patentinhaber : **BODENSEEWERK**
**GERÄTETECHNIK GmbH**
**Alte Nussdorfer Strasse 15,**
**Postfach 101 155**
**D-88641 Überlingen (DE)**

(72) Erfinder : **Rinkenburger, Bertold, Dipl.-Ing.**
**Schillerstrasse 4**
**W-7768 Stockach (DE)**

(74) Vertreter : **Weisse, Jürgen, Dipl.-Phys. et al**
**Patentanwälte Dipl.-Phys. Jürgen Weisse**
**Dipl.-Chem. Dr. Rudolf Wolgast**
**Bökenbusch 41**
**Postfach 11 03 86**
**D-42531 Velbert (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Schaltungsanordnung zum Vergleichen einer Meßfrequenz mit einer mit einem Faktor multiplizierten Referenzfrequenz.

Bei Überwachungsschaltungen für Maschinen tritt die Aufgabe auf, eine Drehzahl mit einem Schwellwert zu vergleichen, der seinerseits von einer anderen Drehzahl abhängt. Es muß daher eine Schaltungsanordnung vorgesehen werden, welche eine Meßfrequenz mit einem Schwellwert vergleicht, der gleich der Referenzfrequenz multipliziert mit einem Faktor ist.

Es sind für diese Zwecke analoge Schaltungen bekannt. Dabei werden die Frequenzen in dazu proportionale Gleichspannungen umgewandelt. Die Multiplikation erfolgt mit Hilfe von Verstärkerschaltungen. Das erfordert einen genauen Abgleich. Die dann erhaltenen analogen Signale werden durch einen analogen Komparator verglichen. Die bekannten analogen Schaltungen dieser Art sind sehr aufwendig, insbesondere wegen des erforderlichen Abgleichs.

Es sind weiterhin Schaltungsanordnungen mit durch Mikroprozessor gesteuerten, digitalen Bauelementen bekannt. Diese Schaltungsanordnungen wandeln die Frequenzen in dazu umgekehrt proportionale Digitalzahlen um. Das geschieht üblicherweise durch Zählen einer hohen Frequenz während einer Periodendauer des Meßsignals. An den so erhaltenen Digitalzahlen führt der Mikroprozessor die erforderlichen Rechenoperationen, z.B. die Multiplikation mit dem Faktor aus. Auch diese Schaltungsanordnungen sind sehr aufwendig. Einmal erfordern sie aufwendige Bauelemente. Zum anderen ist auch eine besondere Software für den Mikroprozessor erforderlich. Eine Schaltungsanordnung dieser Art ist aus der DE-OS 39 06 094 für eine PLL-Schaltung bekannt.

Das Prinzip der Frequenzmessung unter Verwendung von Zählwerken und konstanten Zeitbasen ist an sich bekannt. (Kartaschoff, P.; Frequency and Time, Academic Press, London, Nowe York, San Francisco, 1978, S. 136-142, insbesondere Fig. 5.1). Aus der DE-OS 32 05 240 und aus "Neues aus der Technik", Nr. 4, 15. August 1979, S. 2 sind Vorrichtungen bekannt, bei denen von Rotationskörpern unmittelbar Impulsfolgen abgenommen werden, aus denen sich deren Phasenlage ergibt. Die Impulsfolgen werden in separaten Zählern gezählt und miteinander verglichen. Aus der digitalen Differenz wird ein Analogsignal erhalten anhand dessen die Phasenlage der Rotationskörper in Übereinstimmung gebracht werden kann. Bei dieser insbesondere für Druckmaschinen geeigneten Anordnung findet ein Drehzahlvergleich der oben angegebenen Art nicht statt. Bei der Anordnung nach der US-PS 41 81 884 wird der Vergleich des Signals einer Referenzfrequenz mit der Frequenz des von einer rotierenden Scheibe abgeleiteten Signals zur Bestimmung des Zündwinkels bei einem Verbrennungsmotor verwendet. Bei einer aus der US-PS 39 56 705 bekannten Anordnung wird die von einem Durchfluss-Mengenmesser für Flüssigkeiten abgegebene Impulsfolge mit einer als Referenz dienenden Impulsfolge verglichen um einen Alarm auszulösen, wenn die gemessene Durchflussmenge vom vorbestimmten Wert mehr als zulässig abweicht. Aus der DE-AS 22 41 859 ist eine Anordnung zur Erkennung diskreter Frequenzen, beispielsweise aus einem Frequenzspektrum, bekannt, bei der eine Referenzfrequenz und die zu erkennende Frequenz in Zählern miteinander verglichen werden. Hierbei kann der Ablauf der Zähler zur Erreichung einer anderen scheinbaren Referenzfrequenz durch Programmierung verändert werden. Zum Vergleich der Phasenlagen von Signalen, deren Frequenzen zwar gleich, der Höhe nach aber unbekannt sind, ist aus der DE-OS 19 16 353 eine Schaltung bekannt, bei der die Differenz der Zahlen der Impulse zwischen Zeitmarken ermittelt wird. Aus der DE-OS 21 56 200 ist eine Anordnung bekannt, bei der ohne Verwendung von Induktivitäten aber unter Verwendung aufwendiger Zähl- und Matrixschaltungen, Selektivruf-Frequenzen mit Referenzfrequenzen verglichen werden können, wobei es sich bei beiden Frequenzen auch um sogenannte Gleitfrequenzen handeln kann, bei denen die Frequenz eine Funktion der Zeit ist. Aus der DE-OS 35 20 301 ist ein Phasenvergleicher für eine PLL-Schaltung der Nachrichtentechnik bekannt, bei der zur Ansteuerung von Oszillatoren zwei frequenzmässig geteilte Taktsignale gezählt und unter Anwendung von Kippschaltungen verglichen werden. Auch zur Demodulation frequenzgetasteter Signale werden die Signalfrequenzen mit einer Referenzfrequenz verglichen, die zwischen den Signalfrequenzen liegt (US-PS 44 86 715).

Der Erfindung liegt die Aufgabe zugrunde, eine Schaltungsanordnung zum vergleichen einer Messfrequenz mit einer mit einem Faktor multiplizierten Referenzfrequenz zu schaffen, bei der unter sehr geringem Aufwand eine hohe Präzision und Zuverlässigkeit erreicht wird.

Erfindungsgemäß wird diese Aufgabe gelöst durch

(a) einen ersten Frequenz-Digital-Wandler, auf welchen die Meßfrequenz aufgeschaltet ist,

(b) einen zweiten Frequenz-Digital-Wandler, auf welchen die Referenzfrequenz aufgeschaltet ist und welcher Eingangsfrequenzen in Digitalzahlen umsetzt, die im Vergleich zu dem ersten Frequenz-Digital-Wandler einer mit dem besagten Faktor multiplizierten Frequenz entsprechen, und

(c) einen digitalen Komparator zum Vergleich der digitalen Ausgänge der beiden Frequenz-Digital-Wandler.

Nach der Erfindung wird somit die Multiplikation mit dem Faktor in den Frequenz-Digital-Wandler verlegt.

Das kann durch geeignete Auslegung des Frequenz-Digital-Wandlers ohne zusätzlichen Aufwand geschehen. Weitere Rechenoperationen können entfallen.

Eine bevorzugte Ausgestaltung der Erfindung ist Gegenstand des Patentanspruchs 2.

Ein Ausführungsbeispiel der Erfindung ist nachstehend unter Bezugnahme auf die zugehörigen Zeichnungen näher erläutert.

Fig.1      ist ein Blockschaltbild einer Schaltungsanordnung zum Vergleichen einer Meßfrequenz mit einer mit einem Faktor multiplizierten Referenzfrequenz.

Fig.2      ist ein Blockschaltbild einer Schaltungsanordnung von Fig.1 mit einer bevorzugten Ausbildung der Frequenz-Digital-Wandler.

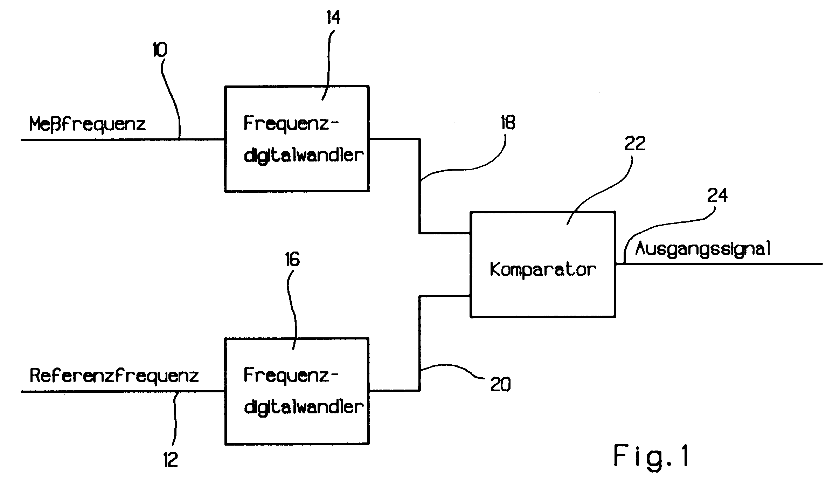

In Fig.1 liegt an einem Eingang 10 ein Signal mit einer Meßfrequenz F1 an. An einem Eingang 12 liegt ein Signal mit einer Referenzfrequenz F2 an. Das Signal vom Eingang 10 ist auf einen ersten Frequenz-Digital-Wandler 14 geschaltet. Das Signal von dem Eingang 12 ist auf einen Frequenz-Digital-Wandler 16 geschaltet. Die beiden Frequenz-Digital-Wandler 14 und 16 liefern Digitalzahlen, die umgekehrt proportional den anliegenden Frequenzen F1 bzw. F2 sind. Die beiden Frequenz-Digital-Wandler sind so ausgelegt, daß bei gleichen Frequenzen an den Eingängen 10 und 12 die Digitalzahlen an den Ausgängen 18 und 20 der Frequenz-Digital-Wandler 14 bzw. 16 im Verhältnis "K" zueinander stehen, wobei K ein konstanter Faktor ist. Die beiden Ausgänge 18 und 20 liegen an einem digitalen Komparator 22 an. Der digitale Komparator liefert ein Ausgangssignal an einem Ausgang 24, wenn

$$F1 < \frac{1}{K} F2$$

ist.

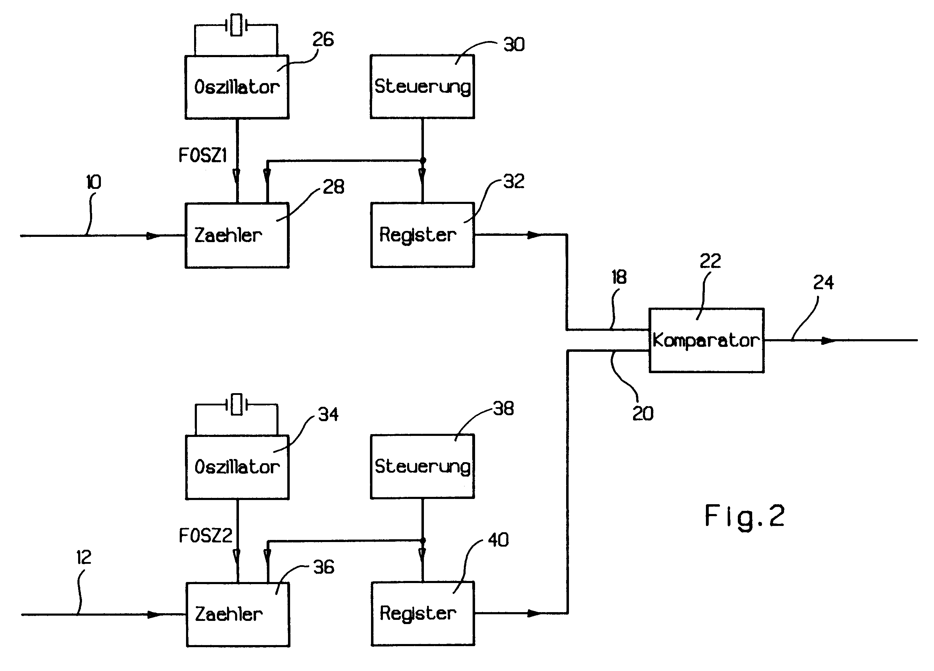

Fig.2 zeigt eine bevorzugte Ausbildung der Frequenz-Digital-Wandler 14 und 16.

Der Frequenz-Digital-Wandler 14 weist einen ersten Oszillator 26 auf. Der Oszillator 26 ist quarzgesteuert und liefert eine hohe Frequenz FOSZ1 von n MHz. Die Frequenz FOSZ1 ist groß gegen die Meßfrequenz F1. Das Signal mit der Frequenz FOSZ1 des Oszillators 26 wird in einen Zähler 28 eingezählt. Eine Steuerung 30 sorgt dafür, daß nach jeweils einer Periode der Meßfrequenz F1 am Eingang 10 der Zählerstand auf ein Register 32 übertragen wird. Gleichzeitig wird der Zähler auf Null zurückgesetzt. Das Register enthält dann eine Digitalzahl, die umgekehrt proportional der Meßfrequenz F1 ist.

In ähnlicher Weise weist der Frequenz-Digital-Wandler 16 einen zweiten Oszillator 34 auf. Der Oszillator 34 ist ebenfalls quarzgesteuert und liefert eine hohe Frequenz FOSZ2 von n.K MHz. Die Frequenz FOSZ2 ist ebenfalls groß gegen die Referenzfrequenz F2. Die Frequenz FOSZ2 des zweiten Oszillators 34 unterscheidet sich von der Frequenz FOSZ1 des ersten Oszillators 26 um den Faktor K. Das Signal mit der Frequenz FOSZ2 des Oszillators 34 wird in einen Zähler 36 eingezählt. Eine Steuerung 38 sorgt dafür, daß nach jeweils einer Periode der Referenzfrequenz F2 am Eingang 12 der Zählerstand auf ein Register 40 übertragen wird. Gleichzeitig wird der Zähler 36 auf Null zurückgesetzt. Das Register 40 enthält dann eine Digitalzahl. die umgekehrt proportional der Referenzfrequenz F2 ist. Bei gleichen Eingangsfrequenzen F1 und F2 ist dabei die Digitalzahl im Register 32 um den Faktor K kleiner als die Digitalzahl im Register 40.

Der Komparator 22 liefert ein Signal am Ausgang 24, wenn $F1 < \frac{1}{K} F2$ wird, wenn also die Digitalzahl im Register 32 größer als die Digitalzahl im Register 40 wird.

## Patentansprüche

1.    Schaltungsanordnung zum Vergleichen einer Meßfrequenz (F1) mit einer mit einem Faktor multiplizierten Referenzfrequenz (F2), **gekennzeichnet durch**

(a) einen ersten Frequenz-Digital-Wandler (14), auf welchen die Meßfrequenz (F1) aufgeschaltet ist und welcher Eingangsfrequenzen in Digitalzahlen umsetzt

(b) einen zweiten Frequenz-Digital-Wandler (16), auf welchen die Referenzfrequenz (F2) aufgeschaltet ist und welcher Eingangsfrequenzen in Digitalzahlen umsetzt, wobei bei Gleichheit der Meßfrequenz (F1) und der Referenzfrequenz (F2) die Digitalzahl des ersten Frequenz-Digital-Wandlers (14) gleich der mit dem besagten Faktor multiplizierten Digitalzahl des zweiten Frequenz-Digital-Wandlers (16) ist,

(c) einen digitalen Komparator (22) zum Vergleich der Digitalzahlen der beiden Frequenz-Digital-Wandler.

2.    Schaltungsanordnung nach Anspruch 1, **dadurch gekennzeichnet, daß**

(a) der erste Frequenz-Digital-Wandler (14)

- einen ersten Oszillator (26) enthält, der eine Signalfolge mit einer gegenüber Meß- und Referenzfrequenz hohen Frequenz liefert,
- einen ersten Zähler (28), in welchen die Signalfolge des ersten Oszillators (26) einzählbar ist, sowie
- ein erstes Register (32), in welches der Zählerstand des ersten Zählers (28) unter gleichzeitiger Rücksetzung des ersten Zählers (28) nach jeder Periode der Meßfrequenz (F1) übertragbar ist,
(b) der zweite Frequenz-Digital-Wandler (16)
- einen zweiten Oszillator (34) enthält, der eine Signalfolge mit einer Frequenz liefert, die gleich der Frequenz der Signalfolge des ersten Oszillators multipliziert mit dem Kehrwert des besagten Faktors ist,
- einen zweiten Zähler (36), in welchen die Signalfolge des zweiten Oszillators (34) einzählbar ist, sowie
- ein zweites Register (40), in welches der Zählerstand des zweiten Zählers (36) unter gleichzeitiger Rücksetzung des zweiten Zählers (36) nach jeder Periode der Referenzfrequenz (F2) übertragbar ist, und
(g) der digitale Komparator (22) zum Vergleich der in den Registern (32,40) gespeicherten Zahlen angeordnet ist.

## Claims

1. Circuit arrangement for comparing a measured frequency (F1) with a reference frequency (F2) which is multiplied by a factor, **characterized by**
   (a) a first digital frequency converter (14) to which the measured frequency (F1) is applied and which converts input frequencies into digital numbers,
   (b) a second digital frequency converter (16) to which the reference frequency (F2) is applied and which converts input frequencies into digital numbers, whereby the digital number of the first digital frequency converter (14) is equal to the digital number of the second digital frequency converter (16) as multiplied by said factor, in the event of equality of the measured frequency (F1) and the reference frequency (F2),
   (c) a digital comparator (22) for comparing the digital numbers issuing from the two digital frequency converters.

2. Circuit arrangement according to claim 1, **characterized in that**
   (a) the first digital frequency converter (14) contains
   - a first oscillator (26) supplying a signal sequence of high frequency as compared to the measured frequency and the reference frequency,
   - a first counter (28) for counting the signal sequence produced by the first oscillator (26), as well as
   - a first register (32) into which the count of the first counter (28) is adapted to be transferred after each period of the measured frequency (F1) with simultaneous resetting of the first counter (28),
   (b) the second digital frequency converter (16) contains
   - a second oscillator (34) supplying a signal sequence at a frequency which is equal to the frequency of the signal sequence produced by the first oscillator as multiplied by the reciprocal of said factor,
   - a second counter (36) for counting the signal sequence produced by the second oscillator (34), as well as
   - a second register (40) into which the count of the second counter (36) is adapted to be transferred after each period of the reference frequency (F2) with simultaneous resetting of the second counter (36), and
   (g) the digital comparator (22) is arranged for comparing the numbers stored in the registers (32,40).

## Revendications

1. Disposition de circuits, destinée à comparer une fréquence de mesure (F1) à une fréquence de référence (F2) multipliée par un facteur, **caractérisée par**
   (a) un premier convertisseur fréquence-digital (14) auquel est appliquée la fréquence de mesure (F1) et qui convertit des fréquences d'entrée en chiffres digitaux,

(b) un second convertisseur fréquence-digital (16) auquel est appliquée la fréquence de référence (F2) et qui convertit des fréquences d'entrée en chiffres digitaux, le chiffre digital du premier convertisseur fréquence-digital (14) étant égal au chiffre digital du second convertisseur fréquence-digital (16), multiplié par ledit facteur, lorsque la fréquence de mesure (F1) est égale à la fréquence de référence (F2),

(c) un comparateur digital (22) destiné à comparer les chiffres digitaux des deux convertisseurs fréquence-digital.

2.  Disposition de circuits selon la revendication 1, **caractérisée par le fait que**

(a) le premier convertisseur fréquence-digital (14)

- comprend un premier oscillateur (26) fournissant une séquence de signaux à fréquence élevée par rapport à la fréquence de mesure et de référence,
- un premier compteur (28) dans lequel on peut lire la séquence de signaux du premier oscillateur (26), ainsi que
- un premier registre (32) dans lequel on peut transmettre la position du premier compteur (28) tout en remettant simultanément le premier compteur (28) après chaque période de la fréquence de mesure (F1),

(b) le second convertisseur fréquence-digital (16) comprend un second oscillateur (34) fournissant une séquence de signaux à une fréquence égale à la fréquence de la séquence de signaux du premier oscillateur, multipliée par la valeur inverse dudit facteur,

- un second compteur (36) dans lequel on peut lire la séquence de signaux du second oscillateur, ainsi que
- un second registre (40) dans lequel on peut transmettre la position du second compteur (36) tout en remettant simultanément le second compteur (36) après chaque période de la fréquence de référence (F2), et

(g) le comparateur digital (22) est disposé afin de comparer les chiffres mémorisés dans les registres (32,40).

Fig.1

EP 0 463 307 B1

Fig.2

EP 0 463 307 B1